# EUROPÄISCHE PATENTSCHRIFT

(11) **EP 2 745 331 B1**
(45) Veröffentlichungstag und Bekanntmachung des Hinweises auf die Patenterteilung: **15.05.2019**
(21) Anmeldenummer: 12751263.0
(22) Anmeldetag: 14.08.2012
(51) Int. Cl.: H01L 31/048, H02G 3/16

(54) **VERTEILERMESSDOSE ZUR STRANGSTROMBESTIMMUNG IN PHOTOVOLTAIKANLAGEN**
JUNCTION BOX FOR DETERMINING STRING CURRENT IN PHOTOVOLTAIC INSTALLATIONS
BOÎTIER RÉPARTITEUR DE MESURE DESTINÉ À DÉTERMINER LE COURANT DE BRANCHE DANS DES INSTALLATIONS PHOTOVOLTAÏQUES

(30) Priorität: 18.08.2011 DE 102011110632
(43) Veröffentlichungstag der Anmeldung: 25.06.2014
(73) Patentinhaber: Phoenix Contact GmbH & Co. KG, 32825 Blomberg (DE)
(72) Erfinder: THÖRNER, Carsten, 49324 Melle (DE)
(74) Vertreter: Blumbach · Zinngrebe Patent- und Rechtsanwälte
(86) Internationale Anmeldenummer: PCT/EP2012/003460
(87) Internationale Veröffentlichungsnummer: WO 2013/023780

(56) Entgegenhaltungen:
- DE-A1-102008 008 503
- DE-U1-202005 018 884
- US-A1- 2006 162 772
- US-A1- 2010 085 670
- US-A1- 2010 300 509
- US-A1- 2011 141 644
- "ABB Anschlusskasten mit Überwachung", Flyer Solar-Wechselrichter, 16. Mai 2011 (2011-05-16), Seiten 1-2, XP55043700, Gefunden im Internet: URL:http://www05.abb.com/global/scot/scot2 01.nsf/veritydisplay/c05a22836cb0ee79c1257 99000307466/$file/DE_Solar_Junction_box_fl yer_3AUA0000100908_DE_REVA.pdf [gefunden am 2012-11-09]

## Beschreibung

### Gebiet der Erfindung

Die Erfindung betrifft eine dezentrale Strangstrombestimmung in Photovoltaikanlagen in einer elektrischen Verteilerdose für ein photovoltaisches Solarmodul.

### Hintergrund der Erfindung

Bei einem Photovoltaikgenerator einer Photovoltaikanlage ist es sinnvoll, eine Strangstrommessung der einzelnen Photovoltaikgeneratorstränge durchzuführen. Die Kenntnis der Einzelstrangströme ermöglicht Rückschlüsse über die Ausbeute der Solarmodule der Einzelstränge und ist ein Indikator für Störungen in der Anlage, wie beispielsweise der Ausfall einzelner Solarmodule.

Üblicherweise ist hierfür in einem Generatorschaltkasten für jeden Strang ein Shuntwiderstand eingebaut, an welchem der Strombetrag der Strangleitung gemessen werden kann. Dies ist zwar ein verbreitet angewendetes Verfahren, es weist aber einige Nachteile auf, für die keine zufriedenstellenden Lösungen zu finden sind.

So ist diesem Verfahren nachteilig, dass für jeden Einzelstrang die Strangleitung bis zu dem Generatorschaltkasten getrennt geführt werden muss, was zu hohen Kosten aufgrund der benötigten Kabellängen führt.

Einer solchen zentralen Strommessung in einem Generatorschaltkasten ist ferner nachteilig, dass die durch die mehreren Shuntwiderstände bei der Strommessung freigesetzte Wärmeleistung aus dem Generatorschaltkasten abgeführt werden muss. Gegebenenfalls erfordert dies die Verwendung von Kühlungslüftern, deren Stromverbrauch den Gesamtertrag des Phtovoltaikgenerators weiter reduziert.

Ein Grund für die Strangstrommessung in dem Generatorschaltkasten ist die feuchtigkeitsgeschützte Unterbringung der für die Strangstrommessung benötigten Bauteile.

Insbesondere bei Photovoltaikanlagen mit einem großen und damit leistungsstarken Photovoltaikgenerator, oder bei langen Kabelstrecken zwischen dem Photovoltaikgenerator und dem Generatorschaltkasten, sind signifikant höhere Kosten durch einen solchen Aufbau aufgrund der Kabelstrecken zu berücksichtigen. Des Weiteren rufen lange Kabelstrecken für jedes Kabel einen Verlust hervor.

Bei der Verwendung von Strommessmodulen zum Einbau in den Photovoltaikgeneratoranschlusskasten entstehen dem Anwender darüber hinaus weitere Kosten, da diese Module zusätzlich zu erwerben und in den Generatoranschlusskasten einzubauen sind.

Dem deutschen Gebrauchsmuster DE 20 2005 018 884 U1 ist beispielhaft eine herkömmliche Anschlussdose für ein Solarpaneel zu entnehmen. Mit einer solchen herkömmlichen Anschlussdose ist keine Strangstrommessung durchführbar.

Der deutschen Offenlegungsschrift DE 10 2008 008 503 A1 ist beispielhaft ein herkömmlicher PV-Teilgenerator-Anschlusskasten für eine zentrale Strommessung zu entnehmen, der die zuvor genannten Nachteile aufweist.

Die Schrift US 2010/0300509 A1 offenbart ein Strommessverfahren für ein photovoltaisches Solarmodul.

### Allgemeine Beschreibung der Erfindung

Die Erfindung hat sich daher die Aufgabe gestellt, die genannten Probleme zu lösen oder zu mindern.

Noch eine Aufgabe der Erfindung ist es, zur Messung des jeweiligen Strangstromes ein redundantes Strangstrommesssystem für jeden Strang des Photovoltaikgenerators zur Verfügung zu stellen.

Eine weitere Aufgabe der Erfindung ist es, Kabelstrecken der Strangleitungen zu verkürzen.

Die Aufgabe der Erfindung wird durch den Gegenstand der unabhängigen Ansprüche gelöst. Vorteilhafte Weiterbildungen der Erfindung sind in den Unteransprüchen definiert.

Erfindungsgemäß wird eine Verteilermessdose bereitgestellt, welche ein Strangstrommessmodul zur Messung der Einzelstrangströme beherbergt. Die Verteilermessdose weist einen rückseitigen Auflageabschnitt, der insbesondere zur Auflage auf einem photovoltaischen Solarmodul ausgebildet ist, eine umlaufende Seitenwand sowie einen Deckel auf. Die umlaufende Seitenwand der Verteilermessdose weist Öffnungen auf, um das Ende einer Strangleitung oder eine kurze Dosenstrangleitung ins Innere der Verteilermessdose zu führen oder an bzw. in der Öffnung zu kontaktieren. Der rückseitige Auflageabschnitt ist insbesondere für eine Klebung vorbereitet.

Die Verteilermessdose weist ferner im Inneren ein Strangstrommessmodul mit einem Messbauteil sowie einer am Messbauteil angeordneten Messelektronik, insbesondere einem Spannungs- oder Strommessgerät, auf. Mit anderen Worten umfasst das Strangstrommessmodul einen Sensor zur Messung des elektrischen Strangstromes sowie eine Auswerteeinrichtung zum Auswerten einer Kenngröße des Sensors und kann demnach als Strommessumformer bezeichnet werden.

Die elektrische Verteilermessdose ist bevorzugt direkt auf der Unterseite eines Solarmoduls angebracht. Die Anbringung der Verteilermessdose direkt auf der sonnenabgewandten Unterseite eines Solarmoduls schützt die Verteilermessdose vor Witterungseinflüssen. Darüber hinaus kann dies die Installation im Falle von Neuanlagen vereinfachen, da die Verteilermessdosen vor der Installation der Solarmodule einfach am rückwärtigen Teil der Solarmodule angebracht, z.B. geklebt werden können. Eine solche Anordnung ist eine einfache Lösung zur Nachrüstung von bereits gefertigten Solarmodulen, an welchen eine Anschluss- und Verbindungsdose, in welche die aus dem Solarmodul heraustretenden elektrischen Leiterbänder eintreten, bereits angebracht ist, mit der erfindungsgemäßen Verteilermessdose.

Die elektrische Verbindung der Verteilermessdose erfolgt z.B. auf der einen Seite mittels einer Dosenverbindungsleitung, die an die Anschluss- und Verbindungsdose des Solarmoduls angeschlossen wird, und auf der anderen Seite mittels einer kurzen Dosenstrangleitung, an deren Ende ein Strangleitungsstecker angebracht ist, oder indem die eine Strangleitung direkt durch die Strangleitungsdurchführung in die Verteilermessdose geführt wird. Zur elektrischen Verbindung der Verteilermessdose mit der Anschluss- und Verbindungsdose kann die Verteilermessdose auch unmittelbar an die Anschluss- und Verbindungsdose angesteckt werden, insbesondere mittels eines Messdosensteckverbinders. Im Falle des unmittelbaren Ansteckens ist die Verteilermessdose demnach zu der Anschluss- und Verbindungsdose direkt benachbart angeordnet.

Mit anderen Worten werden hierbei zwei getrennte Dosen auf ein Solarmodul aufgebracht und miteinander elektrisch verbunden, wobei die elektrische Verbindung entweder mittels einer Dosenstrangleitung zwischen den Dosen oder mittels eines Messdosensteckverbinders hergestellt wird.

In einer besonders bevorzugten Ausführungsform können das Strangstrommessmodul und die aus dem Solarmodul heraustretenden elektrischen Leiterbänder in einer gemeinsamen elektrischen Verteilermessdose integriert werden. In dieser bevorzugten Ausführungsform der Erfindung ist in der Verteilermessdose neben dem Strangstrommessmodul auch der Anschluss des photovoltaischen Solarmoduls angeordnet. Der Anschluss des photovoltaischen Solarmoduls umfasst die aus dem Solarmodul heraustretenden elektrischen Leiterbänder, welche die von dem Solarmodul erzeugte elektrische Leistung an die Strangleitung abführen. Mit anderen Worten handelt es sich dabei um eine modifizierte Anschluss- und Verbindungsdose für ein Solarmodul, wobei in die auf das Solarmodul anzubringende Anschluss- und Verbindungsdose das Strangstrommessmodul integriert ist.

Eine solche Anschluss- und Verbindungsdose umfasst ein zur Auflage auf dem Solarmodul ausgebildeten Auflageabschnitt.

Des Weiteren umfasst eine solche Anschluss- und Verbindungsdose eine elektrische Anschluss- und Verbindungseinrichtung mit einem eingangsseitigen Anschlusselement zum elektrischen Kontaktieren der Leiterbänder einerseits und mit einem ausgangsseitigen Anschlusselement zum elektrischen Kontaktieren der Dosenstrangleitung oder der Strangleitung andererseits, jeweils beispielsweise Anschlussklemmen, um die elektrische Verbindung zwischen den Leiterbändern und den Strangleitungen herzustellen, wenn die Anschluss- und Verbindungsdose an dem Solarmodul angebracht ist.

Die integrierte Anordnung des Strangstrommessmoduls sowie des Anschlusses des Solarmoduls in einer Anschluss- und Verbindungsdose hilft, Fertigungskosten zu verringern, indem Bauteile eingespart werden, wie beispielsweise zwei getrennte Dosengehäuse und zusätzliche externe Verbindungsleitungen.

Überdies kann durch die Anbringung des Strangstrommessmoduls im Bereich der Leiterbänder des Solarmoduls der durch das Strangstrommessmodul hervorgerufene elektrische Verlust weiter verringert werden, indem die Messung des elektrischen Stromes beispielsweise direkt an der Anschluss- und Verbindungseinrichtung für die aus dem Solarmodul heraustretenden Leiterbänder durchgeführt wird.

In einer bevorzugten Ausführungsform des Strangstrommessmoduls in der Anschluss- und Verbindungsdose des photovoltaischen Solarmoduls weist die Anschluss- und Verbindungseinrichtung je zwei über ein starres Brückenelement miteinander verbundene Kontaktklemmen zum lösbaren Anschließen der Leiterbänder einerseits und der Strangleitung andererseits auf. Mittels der Kontaktklemmen ist ein schnelles und sicheres Verbinden der Leiterbänder des Solarmoduls mit den Strangleitungen in der Anschluss- und Verbindungsdose ermöglicht. Das starre Brückenelement ist insbesondere einstückig ausgeführt, z.B. ein gestanztes und geformtes Metallteil, um den elektrischen Verlust weiter zu verringern.

Das Strangstrommessmodul weist in einer Ausführungsform einen Shuntwiderstand sowie eine Spannungsmesseinrichtung am Shuntwiderstand auf, wobei der Shuntwiderstand und die Spannungsmesseinrichtung vorzugsweise in der Anschluss- und Verbindungsdose beherbergt sind. Der Shuntwiderstand ist vorzugsweise in das starre Brückenelement zur Verbindung der Strangleitung mit dem Leiterband des Solarmoduls integriert, so dass die Anschlusselemente über den ShuntWiderstand miteinander verbunden sind. Dies kann die Verlustleistung und den Fertigungsaufwand verringern, da weniger bzw. kompaktere elektrische Bauteile eingesetzt werden können.

In einer weiteren Ausführungsform umfasst das Strangstrommessmodul einen Hallsensor und eine zugehörige Hallsonde zur potentialfreien Messung des Strangstromes. Der Hallsensor umfasst vorzugsweise einen Ringkern für eine magnetische Flussmessung und ist insbesondere an dem starren Brückenelement der Anschluss- und Verbindungseinrichtung oder an der Strangleitungsdurchführung der Verteilermessdose angebracht.

Besonders bevorzugt ist in dem Strangstrommessmodul ein magnetoresistiver Sensor zur Messung des Strangstromes umfasst. Der magnetoresistive Sensor kann beispielsweise an dem starren Brückenelement der Anschluss- und Verbindungseinrichtung oder an der Strangleitungsdurchführung der Verteilermessdose angebracht sein. Insgesamt ermöglicht der magnetoresistive Sensor eine verlustarme Strommessung, wodurch lediglich eine geringe Wärmemenge produziert und abgeführt werden muss. Des Weiteren ist der magnetoresistive Sensor kostengünstig herzustellen. Es sind gerade bei der Integration des magnetoresistiven Sensors in der Anschluss- und Verbindungsdose keine weiteren in den Stromfluss des Solarmoduls eingreifenden bzw. den Stromfluss unterbrechenden Kontakte oder Bauteile benötigt, welche weiteren Leistungsverlust hervorrufen können.

Durch den Einsatz des magnetoresistiven Sensors bzw. des Hallsensors ist demnach auch im Fehlerfall der Messelektronik eine Abgabe der Nutzenergie aus der Solaranlage an nachgelagerte Wechselrichter möglich.

Insbesondere wird der magnetoresistive Sensor direkt an dem starren Brückenelement der Anschluss- und Verbindungseinrichtung oder an einer der Strangleitungsdurchführungen der Verteilermessdose angebracht. Die Anbringung an der Strangleitungsdurchführung der Verteilermessdose ist auch in dem Fall möglich, wenn die Verteilermessdose nicht die Anschluss- und Verbindungsdose des Solarmoduls ist, in der die Leiterbänder beherbergt sind. Der magnetoresistive Sensor weist insbesondere eine derart geringe Baugröße auf, dass die Bauform der Anschluss- und Verbindungsdose des photovoltaischen Solarmoduls nicht verändert werden muss.

Insbesondere ist vorgesehen, lediglich ein Strangstrommessmodul für einen gesamten Strang des Photovoltaikgenerators zu verwenden oder zu aktivieren. Gegebenenfalls kann es aber günstiger sein, die Anschluss- und Verbindungsdosen aller photovoltaischen Solarmodule mit jeweils einem Strangstrommessmodul auszurüsten, wobei es nicht erforderlich ist, die ausgegebene Kenngröße aller Strangstrommessmodule auszuwerten.

Stehen mehrere Strangstrommessmodule in einem Strang gleichzeitig für eine Auswertung zur Verfügung, ist darüber hinaus ein redundanter Messbetrieb ermöglicht. Dies kann die Ausfallsicherheit erhöhen, da eine große Anzahl Strangstrommessmodule als Reserve zur Verfügung steht. Bei der Verwendung des magnetoresistiven Sensors kann hierbei auch bei Ausfall eines Sensors die Solaranlage störungsfrei weiter betrieben werden und weiter der Strangstrom gemessen werden, indem die Kenngröße eines anderen Strangstrommessmoduls desselben Stranges ausgelesen wird.

Die für die Messung der elektrischen Kenngröße mittels des Strangstrommessmoduls erforderliche elektrische Leistung wird insbesondere direkt aus dem Solarmodul bzw. dem Generatorstrang bezogen, auf bzw. in welchem das Strangstrommessmodul angeordnet ist. Hierdurch entfällt eine zusätzliche Verkabelung für die Stromversorgung der Strangstrommessmodule.

Eine weitere Ausführungsform der Verteilermessdose umfasst eine Funkübertragungseinrichtung zum Übertragen der von dem Strangstrommessmodul gemessenen Wert der Kenngröße an eine zentrale Auswerteeinrichtung. Diese Daten können auch über die Strangkabel selbst ("PowerLine communication") übertragen werden. Mit beiden Verfahren ist ein einfaches und sicheres Auslesen der mit dem Strangstrommessmodul erzeugten Messdaten gegeben.

Erfindungsgemäß ist auch eine Photovoltaikanlage mit einer Mehrzahl von photovoltaischen Solarmodulen, wobei die photovoltaischen Solarmodule mit Verteilermessdosen ausgerüstet sind und wobei in jedem Strang der Photovoltaikanlage zumindest ein an einem Solarmodul in einer Verteilermessdose angeordnetes Strangstrommessmodul eingesetzt ist zum Messen des Strangstromes.

Bevorzugt weist eine solche Photovoltaikanlage eine zentrale Auswerteeinrichtung auf, mittels welcher die von den Strangstrommessmodulen erzeugten Messwerte erfasst und ausgewertet werden können. Beispielsweise ist eine solche zentrale Auswerteeinrichtung ein Arbeitsplatzcomputer, welcher ein Empfangs- und/oder Übertragungsmittel aufweist, welches mit dem Strangstrommessmodul der Verteilermessdose verbunden werden kann.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine erste Ausführungsform der Verteilermessdose mit Strangstrommessmodul,
- Fig. 2: eine zweite Ausführungsform der Verteilermessdose,
- Fig. 3: eine dritte Ausführungsform der Verteilermessdose mit einem magnetoresistiven Widerstand,
- Fig. 4: eine Ausführungsform insbesondere zum Nachrüsten eines Solarmoduls, wobei eine Anschluss- und Verbindungsdose des Solarmoduls und eine Verteilermessdose gezeigt ist,
- Fig. 5: Eine Ausführungsform analog der Fig. 4, wobei die Anschluss- und Verbindungsdose mit der Verteilermessdose über einen Messdosensteckverbinder verbunden ist,
- Fig. 6: eine Ausführungsform der Verteilermessdose als Anschluss- und Verbindungsdose eines Solarmoduls,
- Fig. 7: ein photovoltaisches Solarmodul mit einer Anschluss- und Verbindungsdose und einer Verteilermessdose.

### Detaillierte Beschreibung der Ausführungsbeispiele

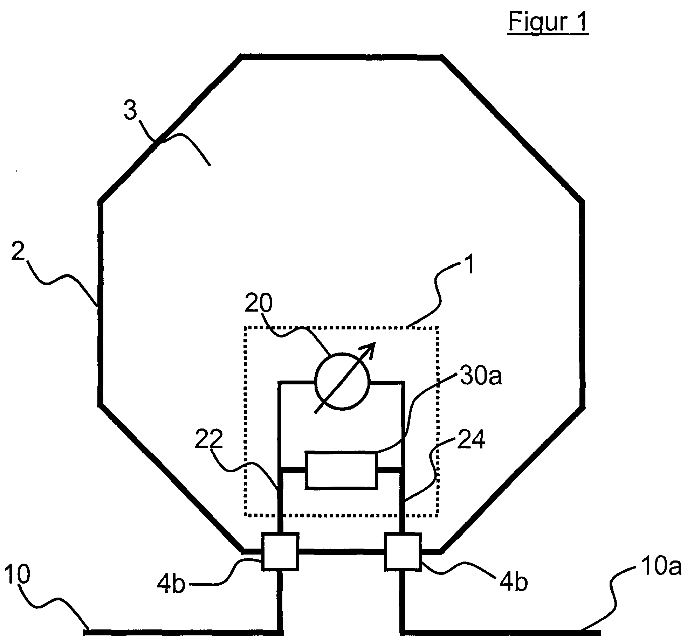

Die in Fig. 1 dargestellte Verteilermessdose 2 weist eine Unterseite auf, die zur Auflage auf einem Solarmodul ausgebildet ist und somit einen Auflageabschnitt 3 bildet. Der Auflageabschnitt 3 kann Befestigungslöcher aufweisen oder für eine Klebung vorgesehen sein. Die Verteilermessdose 2 hat ferner eine umlaufende Seitenwand 5, in welcher Öffnungen 4 zur Durchführung oder zum Anschluss der Strangleitungen, Dosenstrangleitungen oder der Messdosenverbindungsleitung 10, 10a, 12 vorgesehen sind. Mit anderen Worten kann durch eine Strangleitungsdurchführung 4a eine Strangleitung hindurchgeführt werden und an einen Strangleitungsverbinder 4b kann eine Strangleitung z.B. mittels eines Steckverbinders angeschlossen werden. Im gezeigten Ausführungsbeispiel der Figur 1 ist ein Leitungsverbinder 4b eingesetzt. Die Strangleitung 10 verbindet dabei einen ersten Pol des Photovoltaikgenerators mit der Verteilermessdose 2, die Messdosenverbindungsleitung 10a verbindet die Verteilermessdose mit der Anschluss- und Verbindungsdose des Solarmoduls und im Weiteren mit einem zweiten elektrischen Pol des Photovoltaikgenerators, wobei sich ggf. zwischen dem jeweiligen Pol und der Verteilermessdose 2 weitere Solarmodule befinden können.

Die Verteilermessdose 2 beherbergt ein Strangstrommessmodul 1. In der Verteilermessdose 2 ist eine Dosenstrangleitung 22 an den Strangleitungsverbinder 4b und mit dem weiteren Ende an ein Messbauteil 30 angeschlossen, die Strangleitung 10 wird an den Strangleitungsverbinder 4b angeschlossen. Es kann auch vorgesehen sein, die Strangleitung 10 durch die Strangleitungsdurchführung 4a hindurchzuführen und mit ihrem Ende direkt das Messbauteil 30 zu kontaktieren, oder die Dosenstrangleitung 22 vormontiert durch die Strangleitungsdurchführung 4a nach außen zu verlegen und außerhalb der Verteilermessdose 2 mit einem Stecker auszurüsten, so dass die Strangleitung 10 außerhalb der Verteilermessdose 2 elektrisch kontaktiert wird. In jedem Fall wird eine elektrische Verbindung mit dem jeweiligen elektrischen Pol des Photovoltaikgenerators hergestellt, wobei der Fachmann die für den Einzelfall geeignete Verbindungslösung auswählen wird.

Das Messbauteil 30 ist in der Ausführungsform der Figur 1 ein Shuntwiderstand 30a, an welchem mittels eines Spannungsmessgeräts 20 die abfallende Spannung gemessen wird. Aufgrund des gemessenen Spannungswertes U und dem bekannten Widerstandswert R des Shuntwiderstands 30a kann der durch den Shuntwiderstand 30a fließende Strom I bestimmt werden.

Eine weitere Dosenstrangleitung 24 verbindet den Ausgang des Shuntwiderstandes 30a mit dem Strangleitungsverbinder 4b, so dass mit der Messdosenverbindungsleitung 10a eine Verbindung mit der Anschluss- und Verbindungsdose des Solarmoduls und im Weiteren mit dem zweiten Pol des Photovoltaikgenerators oder mit weiteren Solarmodulen ermöglicht ist.

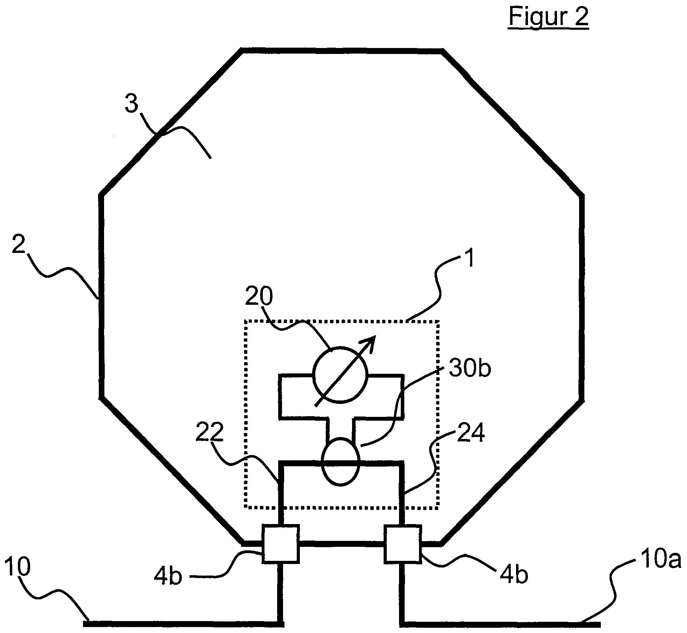

In einer weiteren Ausführungsform der Erfindung gemäß Figur 2 ist in der Verteilermessdose 2 ein Ringkern umfasst, der als Hallsensor 30b funktioniert. An den Ringkern ist ein Spannungsmessgerät 20 angeschlossen.

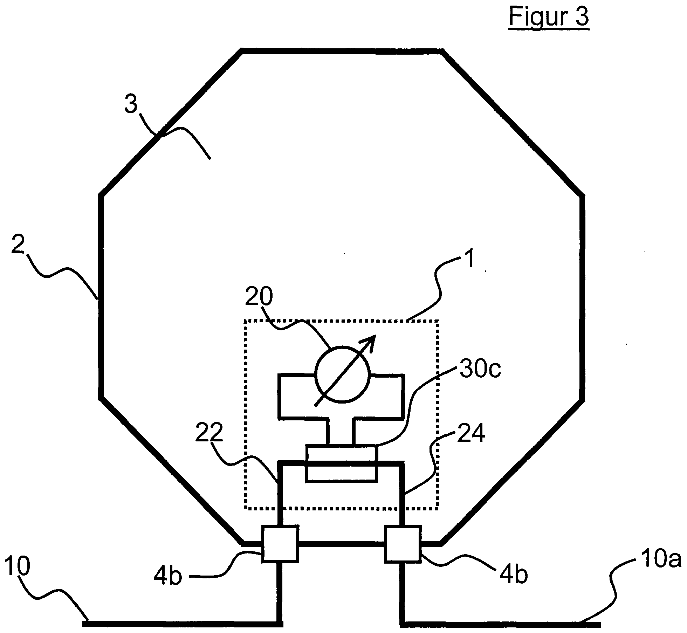

Figur 3 zeigt eine bevorzugte Ausführungsform der Erfindung, wobei als Messbauteil 30 ein magnetoresistiver Sensor 30c verwendet wird. Der magnetoresistive Sensor 30c umschließt die elektrische Leitung derart, dass die den elektrischen Leiter umgebenden Wirbelströme detektiert werden. Somit ist die Spannungsmessung mittels des magnetoresistiven Sensors 30c nicht invasiv, d.h., dass die Strangleitung von dem Strangstrommessmodul 1 nicht unterbrochen ist und eine besonders widerstandsarme Messung stattfindet.

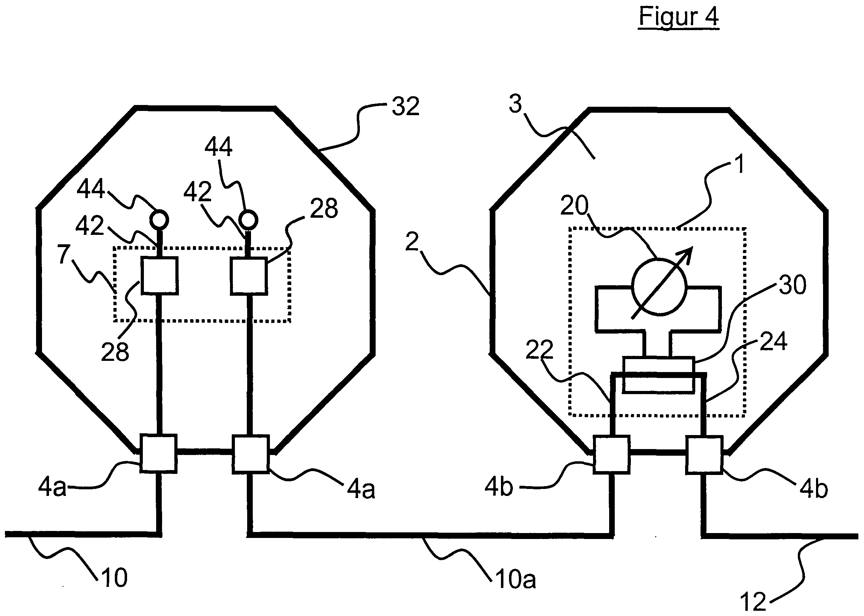

Figur 4 zeigt eine Ausführungsform mit zwei getrennten Gehäusen, der Verteilermessdose 2 mit dem Strangstrommessmodul 1 sowie der Anschluss- und Verbindungsdose 32, in welcher die aus dem Solarmodul heraustretenden elektrischen Leiterbänder 42 kontaktiert sind. Die Ausführungsform zeigt damit den Einsatz der mit Figuren 1 bis 3 gezeigten Verteilermessdosen in Verbindung mit der Anschluss- und Verbindungsdose.

In der Anschluss- und Verbindungsdose 32 sind die aus dem Solarmodul heraustretenden elektrischen Leiterbänder 42, die an Kontakte 44 des Solarmoduls angeschlossen sind bzw. an der mit der Ziffer 44 bezeichneten Stelle aus dem Solarmodul austreten, kontaktiert. Die Leiterbänder 42 sind jeweils an ein Anschlusselement 28 der Anschluss- und Verbindungseinrichtung 7 angeschlossen.

Eine erste Strangleitung 10 verbindet einen ersten elektrischen Pol des Photovoltaikgenerators durch die Strangleitungsdurchführung 4a direkt mit dem ersten Anschlusselement 28 in der Anschluss- und Verbindungsdose und mit dem ersten Leiterband 42. Die Strangleitung 10 ist dabei in etwa auf die Abmessungen des Solarmoduls beschränkt und weist am externen Ende einen Stecker auf zum Verbinden mit einer weiteren Strangleitung oder mit einem weiteren Solarmodul. Der elektrische Stromfluss führt durch das photovoltaische Solarmodul und die einzelnen Solarzellen über das zweite Leiterband 42 und das zweite Anschlusselement 28, an die Messdosenverbindungsleitung 10a, die durch die Strangleitungsdurchführung 4a hindurch die Anschluss- und Verbindungsdose 32 mit der Verteilermessdose 2 verbindet.

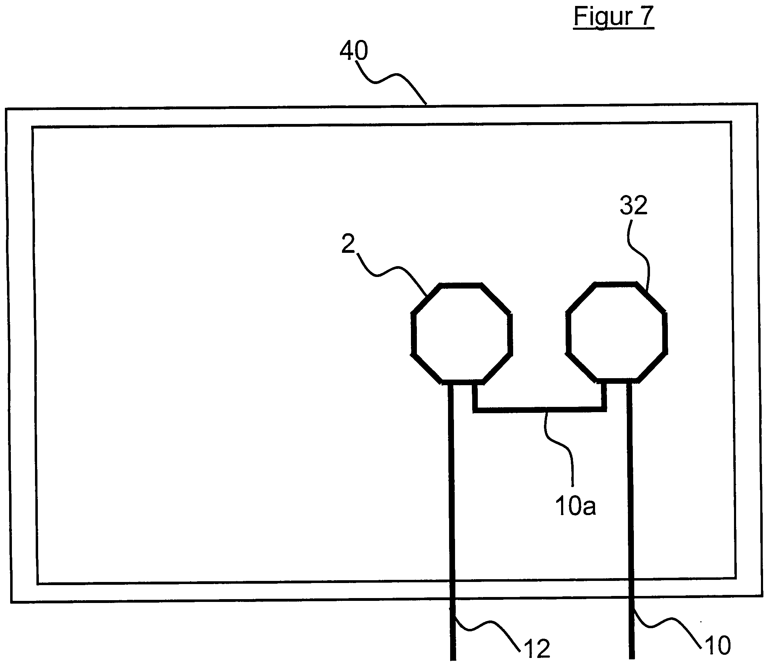

In der Verteilermessdose 2 ist das Strangstrommessmodul 1 beherbergt. Der weitere Aufbau der Verteilermessdose ist identisch dem in Figur 3 gezeigten Aufbau. Eine zweite Strangleitung 12 verbindet schließlich die Verteilermessdose 2 mit dem zweiten elektrischen Pol des Photovoltaikgenerators. Diese Ausführungsform der Erfindung ist besonders geeignet zur Nachrüstung von bereits bestehenden Solarmodulen oder zur Nachrüstung von bereits montierten Solaranlagen. So kann die Verteilermessdose 2 in einfacher Weise auf die bereits installierten Solarmodule zusätzlich zur vorhandenen Anschluss- und Verbindungsdose 32 unterseitig aufgeklebt oder anderweitig befestigt werden und der elektrische Kontakt der ersten Strangleitung 12 mit der nachgerüsteten Verteilermessdose 2 verbunden werden. Die weitere auf die Rückseite dieses Solarmoduls beschränkte Messdosenverbindungsleitung 10a wird mit der vorhandenen Anschluss und Verbindungsdose 32 verbunden (vgl. Fig. 7). Ein weiterer Montageaufwand ist nicht nötig.

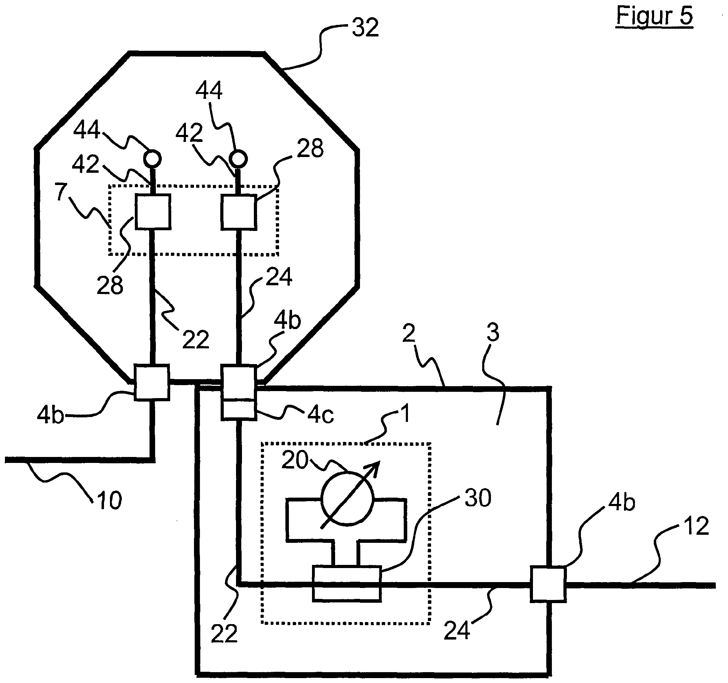

Figur 5 zeigt eine Ausführungsform der Erfindung mit zwei getrennten Gehäusen, wobei die Verteilermessdose 2 mit der Anschluss- und Verbindungsdose 32 über einen Messdosensteckverbinder 4c elektrisch verbunden ist.

Der Messdosensteckverbinder 4c ist mit dem Strangleitungsverbinder 4b paarbar ausgeführt, wobei im gezeigten Beispiel der Messdosensteckverbinder 4c in der Verteilermessdose 2 und der Strangleitungsverbinder 4b in der Anschluss- und Verbindungsdose beherbergt ist. In dieser Ausführungsform wird die Verteilermessdose 2 demnach direkt an die Anschluss- und Verbindungsdose 32 angesteckt. Die Verteilermessdose 2 und die Anschluss- und Verbindungsdose 32 sind in dieser Ausführungsform im zusammengesteckten Zustand unmittelbar benachbart. Der Messdosensteckverbinder 4c wird hierbei mit dem Strangleitungsverbinder 4b zusammengesteckt. In diesem Beispiel kann also auf die Messdosenverbindungsleitung 10a verzichtet werden. Die Verteilermessdose 2 ist auch in dieser Ausführungsform wie in dem mit Fig. 3 gezeigten Beispiel mit Strangleitungsverbindern 4b für den Anschluss der Strangleitungen 10, 12 ausgerüstet.

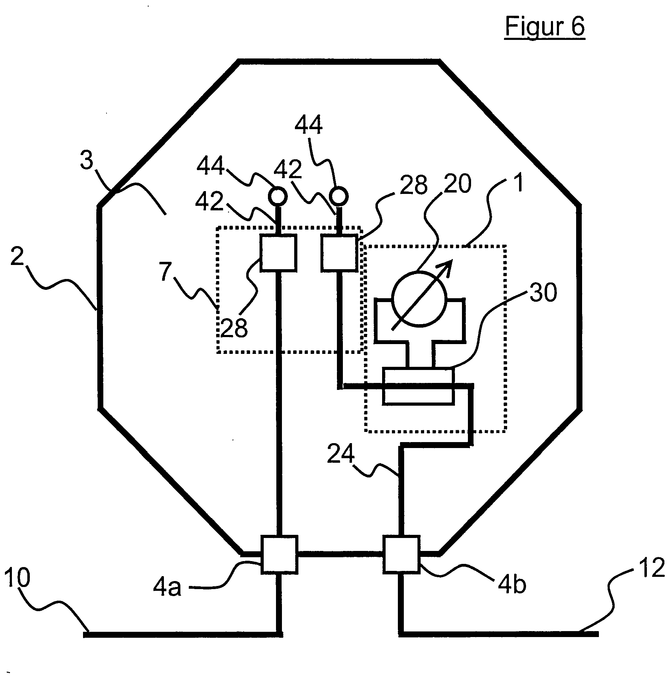

Figur 6 zeigt eine weitere Ausführungsform der Erfindung, wobei in der Verteilermessdose 2 zugleich auch die aus dem Solarmodul heraustretenden elektrischen Leiterbänder 42, die an Kontakte 44 des Solarmoduls angeschlossen sind bzw. an der mit der Ziffer 44 bezeichneten Stelle aus dem Solarmodul austreten, kontaktiert werden. Die Leiterbänder 42 sind jeweils an ein Anschlusselement 28 der Anschluss- und Verbindungseinrichtung angeschlossen. Das Anschlusselement 28 ist mit einem weiteren Ende mittels der Dosenstrangleitungen 22, 24 an die Strangleitungen 10, 12 angeschlossen. Somit ist ein elektrischer Stromkreis von der ersten Strangleitung 10 über die Dosenstrangleitung 22, die Leiterbänder 42, die Dosenstrangleitung 24 und die weitere Strangleitung 12 gebildet.

In der Verteilermessdose 2 ist ferner das Strangstrommessmodul 1 beherbergt. Das Strangstrommessmodul 1 umfasst in der gezeigten Ausführungsform den magnetoresistiven Sensor 30c, an welchen die Spannungsmesseinrichtung 20 angeschlossen ist zur Messung der an dem magnetoresistiven Sensor 30c induzierten Spannung.

So ist in besonders vorteilhafter Weise die gesamte benötigte Verbindungseinrichtung für ein Solarmodul in einer Verteilermessdose 2 beherbergt. Mit anderen Worten ist die Verteilermessdose 2 zugleich auch die Anschluss- und Verbindungsdose 32 des Solarmoduls. Dies senkt Produktions-, Logistik- und Montagekosten.

Figur 7 zeigt den unterseitig auf einem Solarmodul 40 montierten Zustand von Verteilermessdose 2 und Anschluss- und Verbindungsdose 32. Die erste Strangleitung 12 ist in der gezeigten Ausführungsform mit der Verteilermessdose 2 verbunden, die auf die Abmessungen dieses Solarmoduls beschränkte Messdosenverbindungsleitung 10a verbindet die Verteilermessdose 2 mit der Anschluss- und Verbindungsdose 32, und die Strangleitung 10 verbindet schließlich den zweiten elektrischen Pol des Photovoltaikgenerators mit der Anschluss- und Verbindungsdose 32.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann. Der Schutzumfang der vorliegenden Erfindung wird durch die angefügten Ansprüche bestimmt.

### Bezugszeichenliste:

- 1: Strangstrommessmodul
- 2: Verteilermessdose
- 3: Auflageabschnitt
- 4: Öffnung
- 4a: Strangleitungsdurchführung
- 4b: Strangleitungsverbinder
- 4c: Messdosensteckverbinder
- 7: Anschluss- und Verbindungseinrichtung
- 10: Strangleitung
- 10a: Messdosenverbindungsleitung
- 12: Strangleitung
- 20: Auswertungseinrichtung
- 22: Dosenstrangleitung
- 24: Dosenstrangleitung
- 28: Anschlusselement
- 30: Messbauteil
- 30a: Shuntwiderstand
- 30b: Hallsensor
- 30c: Magnetoresistiver Sensor
- 40: Photovoltaisches Solarmodul
- 42: Leiterband
- 44: Leiterbandanschluss oder Leiterbandaustrittsöffnung

## Patentansprüche

1. Verteilermessdose (2), hergerichtet zur Montage auf einem photovoltaischen Solarmodul (40), umfassend:
ein Gehäuse mit einem zur Auflage auf dem Solarmodul ausgebildeten Auflageabschnitt (3), einer umlaufenden Seitenwand und einem Deckel,
Strangleitungsdurchführungen (4a) und/oder Strangleitungsverbinder (4b),
**dadurch gekennzeichnet, dass**
die Verteilermessdose (2) ein Strangstrommessmodul (1) mit einem Messbauteil (30, 30a, 30b, 30c) und einer Auswertungseinrichtung (20) zur Messung des Strangstroms in der Verteilermessdose (2) umfasst,
wobei die Verteilermessdose ferner eine Messdosenverbindungsleitung (10a) zum Verbinden der Verteilermessdose (2) mit einer Anschluss- und Verbindungsdose (32) des Solarmoduls (40), oder einen Messdosensteckverbinder (4c), mit dem die Verteilermessdose (2) unmittelbar an die Anschluss- und Verbindungsdose (32) ansteckbar ist, umfasst
so dass die Verteilermessdose (2) und die Anschluss- und Verbindungsdose (32) als getrennte Dosen mit jeweils eigenem Gehäuse zur Montage auf demselben photovoltaischen Solarmodul (40) ausgebildet sind,
ODER
wobei die Verteilermessdose ferner eine Anschluss- und Verbindungseinrichtung (7) zum elektrischen Kontaktieren von Leiterbändern (42) des Solarmoduls (40) einerseits und zum Anschließen der und Verbinden mit der Strangleitung (10, 12) oder einer Dosenstrangleitung (22, 24) andererseits umfasst, um die elektrische Verbindung zwischen den Leiterbändern (42) und den Strangleitungen (10, 12) herzustellen, wenn die Verteilermessdose (2) an dem Solarmodul (40) angebracht ist, um die von dem Solarmodul erzeugte elektrische Leistung abzuführen, so dass die Verteilermessdose zugleich die Anschluss- und Verbindungsdose des Solarmoduls bildet.

2. Verteilermessdose nach vorstehendem Anspruch,
wobei die Anschluss- und Verbindungseinrichtung (7) je zwei über ein starres Brückenelement miteinander verbundene Klemmen zum lösbaren Anschließen und elektrischem Kontaktieren der Leiterbänder (42) einerseits und der Strangleitung (10, 12) oder der Dosenstrangleitung (22, 24) andererseits aufweisen.

3. Verteilermessdose nach einem der vorstehenden Ansprüche,
wobei das Strangstrommessmodul (1) einen Shuntwiderstand (30a) und eine Spannungsmesseinrichtung (20) am Shuntwiderstand in der Verteilermessdose (2) umfasst.

4. Verteilermessdose nach vorstehendem Anspruch,
wobei der Shuntwiderstand (30a) in dem starren Brückenelement der Anschluss- und Verbindungseinrichtung (7) integriert ist, so dass die Anschlusselemente der Anschluss- und Verbindungseinrichtung (7) über den Shuntwiderstand (30a) miteinander elektrisch verbunden sind.

5. Verteilermessdose (2) nach einem der Ansprüche 1 oder 2,
wobei das Strangstrommessmodul (1) einen Hallsensor (30b) und eine zugehörige Hallsonde (20) zur unterbrechungsfreien Messung des Strangstromes umfasst.

6. Verteilermessdose (2) nach vorstehendem Anspruch,
wobei der Hallsensor (30b) einen Ringkern für eine magnetische Flussmessung des in der Verteilermessdose (2) durch die Strangleitung fließenden Stromes umfasst und
wobei der Hallsensor (30b) an dem starren Brückenelement der Anschluss- und Verbindungseinrichtung (7) oder an der Strangleitungsdurchführung (4b) der Verteilermessdose (2) angebracht ist.

7. Verteilermessdose (2) nach einem der Ansprüche 1 oder 2,
wobei das Strangstrommessmodul (1) einen magnetoresistiven Sensor (30c) zur Messung des Strangstromes umfasst.

8. Verteilermessdose nach vorstehendem Anspruch,
wobei der magnetoresistive Sensor (30c) an dem starren Brückenelement der Anschluss- und Verbindungsdose (32) oder an der Strangleitungsdurchführung (4a) der Verteilermessdose (2) angebracht ist, so dass in der Verteilermessdose (2) aus dem von dem Strangstrom erzeugten magnetischen Fluss die Strommessung ermöglicht ist.

9. Verteilermessdose nach einem der vorstehenden Ansprüche, ferner umfassend:
Mittel zum Übertragen der von dem Strangstrommessmodul (1) in der Verteilermessdose (2) gemessenen Werte an eine zentrale Auswerteeinrichtung.

10. Photovoltaisches Solarmodul mit einer Mehrzahl von Solarzellen,
wobei auf der sonnenabgewandten Rückseite des photovoltaischen Solarmoduls (40) eine Verteilermessdose (2) nach einem der vorstehenden Ansprüche angebracht ist.

11. Photovoltaikanlage mit einer Mehrzahl von photovoltaischen Solarmodulen (40) nach vorstehendem Anspruch,
mit einer Mehrzahl von Strangleitungen (10, 10a 12),
mit einem Generatoranschlusskasten,
mit zumindest einem Wechselrichter zur Einspeisung der mit dem Photovoltaikgenerator erzeugten elektrischen Leistung.

12. Photovoltaikanlage nach vorstehendem Anspruch mit einer zentralen Auswerteeinrichtung zum Erfassen und Auswerten der von den Strangstrommessmodulen der Verteilermessdosen (2) übertragenen Werte.

## Claims

1. A junction measurement box (2), configured for being mounted on a photovoltaic solar module (40), comprising:
a housing having a support section (3) formed for being supported on the solar module, a circumferential side wall, and a lid;
string line feedthroughs (4a) and/or string line connectors (4b);
**characterized in that**
the junction measurement box (2) comprises a string current measuring module (1) including a measuring component (30, 30a, 30b, 30c) and an evaluation device (20) for measuring the string current in the junction measurement box (2);
wherein the junction measurement box further comprises a measurement box connection line (10a) for connecting the junction measurement box (2) to a junction and connection box (32) of the solar module (40), or a measurement box plug-in connector (4c) that allows the junction measurement box (2) to be directly plugged to the junction and connection box (32),
so that the junction measurement box (2) and the junction and connection box (32) are embodied as separate boxes, each one with its own housing for being mounted on the same photovoltaic solar module (40);
OR
wherein the junction measurement box further comprises a junction and connection device (7) for electrically contacting conductor strips (42) of the solar module (40) on one side and for producing junctions and connections with the string line (10, 12) or a box string line (22, 24) on the other side, in order to establish the electrical connection between the conductor strips (42) and the string lines (10, 12) when the junction measurement box (2) is mounted on the solar module (40) for delivering the electrical power generated by the solar module, so that the junction measurement box at the same time defines the junction and connection box of the solar module.

2. The junction measurement box according to the preceding claim,
wherein the junction and connection device (7) comprises a pair of terminals interconnected via a rigid bridging element, for releasably connecting and electrically contacting the conductor strips (42) on one side and the string line (10, 12) or the box string line (22, 24) on the other side.

3. The junction measurement box according to any one of the preceding claims,
wherein the string current measuring module (1) comprises a shunt resistor (30a) and a voltage measuring device (20) on the shunt resistor inside the junction measurement box (2).

4. The junction measurement box according to the preceding claim,
wherein the shunt resistor (30a) is integrated in the rigid bridging element of the junction and connection device (7), so that the connection elements of the junction and connection device (7) are electrically connected to one another via the shunt resistor (30a).

5. The junction measurement box (2) according to any one of claims 1 or 2,
wherein the string current measuring module (1) comprises a Hall sensor (30b) and an associated Hall probe (20) for uninterrupted measurement of the string current.

6. The junction measurement box (2) according to the preceding claim,
wherein the Hall sensor (30b) comprises a toroidal core for measuring a magnetic flux of the current flowing through the string line within the junction measurement box (2); and
wherein the Hall sensor (30b) is mounted on the rigid bridging element of the junction and connection device (7) or on the string line feedthrough (4b) of the junction measurement box (2).

7. The junction measurement box (2) according to any one of claims 1 or 2,
wherein the string current measuring module (1) comprises a magnetoresistive sensor (30c) for measuring the string current.

8. The junction measurement box according to the preceding claim,
wherein the magnetoresistive sensor (30c) is mounted on the rigid bridging element of the junction and connection box (32) or on the string line feedthrough (4a) of the junction measurement box (2) so that current measurement in the junction measurement box (2) can be achieved based on the magnetic flux generated by the string current.

9. The junction measurement box according to any one of the preceding claims, further comprising:
means for transmitting the values measured by the string current measuring module (1) inside the junction measurement box (2) to a central evaluation device.

10. A photovoltaic solar module, comprising a plurality of solar cells,
wherein a junction measurement box (2) according to any one of the preceding claims is mounted on a rear side of the photovoltaic solar module (40) facing away from the sun.

11. A photovoltaic system, comprising a plurality of photovoltaic solar modules (40) according to the preceding claim, comprising
a plurality of string lines (10, 10a, 12);
a generator junction box;
at least one inverter for supplying the electrical power generated by the photovoltaic generator.

12. The photovoltaic system according to the preceding claim, comprising a central evaluation device for acquiring and evaluating the values transmitted by the string current measuring modules of the junction measurement boxes (2).

## Revendications

1. Boîte de distribution de mesure (2) agencée pour le montage sur un modulaire solaire photovoltaïque (40), comprenant :
un boîtier comportant une partie d'appui (3) conçue en vue d'un appui sur le module solaire, une paroi latérale périphérique et un couvercle,
des traversées de lignes de branche (4a) et/ou des connecteurs de lignes de branche (4b),
**caractérisée en ce que**
la boîte de distribution de mesure (2) comprend un module de mesure de courant de branche (1) comportant un composant de mesure (30, 30a, 30b, 30c) et un dispositif d'évaluation (20) destinés à mesurer le courant de branche dans la boîte de distribution de mesure (2),
sachant que la boîte de distribution de mesure comprend en outre une ligne de raccordement de boîte de mesure (10a), destinée à raccorder la boîte de distribution de mesure (2) à une boîte de connexion et de raccordement (32) du module solaire (40), ou un connecteur enfichable de boîte de mesure (4c) qui permet d'enficher la boîte de distribution de mesure (2) directement sur la boîte de connexion et de raccordement (32),
de sorte que la boîte de distribution de mesure (2) et la boîte de connexion et de raccordement (32) sont réalisées en tant que boîtes séparées, comportant chacune un boîtier distinct pour le montage sur le même module solaire photovoltaïque (40),
OU
sachant que la boîte de distribution de mesure comprend en outre un dispositif de connexion et de raccordement (7) destiné à établir le contact électrique de rubans conducteurs (42) du module solaire (40), d'une part, et à connecter ou raccorder la ligne de branche (10, 12) ou une ligne de branche de boîte (22, 24), d'autre part, afin d'établir la liaison électrique entre les rubans conducteurs (42) et les lignes de branche (10, 12), lorsque la boîte de distribution de mesure (2) est montée sur le module solaire (40) pour évacuer la puissance électrique produite par le module solaire, de sorte que la boîte de distribution de mesure constitue en même temps la boîte de connexion et de raccordement du module solaire.

2. Boîte de distribution de mesure selon la revendication précédente, dans laquelle le dispositif de connexion et de raccordement (7) présente respectivement deux bornes, reliées l'une à l'autre par un élément en pont rigide, en vue de la connexion amovible et de l'établissement du contact électrique des rubans conducteurs (42), d'une part, et de la ligne de branche (10, 12) ou de la ligne de branche de boite (22, 24), d'autre part.

3. Boîte de distribution de mesure selon l'une des revendications précédentes, dans laquelle le module de mesure de courant de branche (1) comprend une résistance en dérivation (30a) et un dispositif de mesure de tension (20) sur la résistance en dérivation, dans la boîte de distribution de mesure (2).

4. Boîte de distribution de mesure selon la revendication précédente, dans laquelle la résistance en dérivation (30a) est intégrée dans l'élément en pont rigide du dispositif de connexion et de raccordement (7), de sorte que les éléments de connexion du dispositif de connexion et de raccordement (7) sont reliés électriquement entre eux par l'intermédiaire de la résistance en dérivation (30a).

5. Boîte de distribution de mesure (2) selon l'une des revendications 1 ou 2, dans laquelle le module de mesure de courant de branche (1) comprend un capteur à effet Hall (30b) et une sonde de Halle (20) associée, en vue de mesurer sans interruption le courant de branche.

6. Boîte de distribution de mesure selon la revendication précédente, dans laquelle le capteur à effet Hall (30b) comprend un noyau toroïdal pour une mesure de flux magnétique du courant circulant dans la boîte de distribution de mesure (2), à travers la ligne de branche, et
dans laquelle le capteur à effet Hall(30b) est monté sur l'élément en pont rigide du dispositif de connexion et de raccordement (7) ou sur la traversée de ligne de branche (4b) de la boîte de distribution de mesure (2).

7. Boîte de distribution de mesure (2) selon l'une des revendications 1 ou 2, dans laquelle le module de mesure de courant de branche (1) comprend un capteur magnétorésistif (30c) destiné à mesurer le courant de branche.

8. Boîte de distribution de mesure selon la revendication précédente, dans laquelle le capteur magnétorésistif (30c) est monté sur l'élément en pont rigide de la boîte de connexion et de raccordement (32) ou sur la traversée de ligne de branche (4a) de la boîte de distribution de mesure (2), de sorte que dans la boîte de distribution de mesure (2), la mesure du courant à partir du flux magnétique produit par le courant de branche est possible.

9. Boîte de distribution de mesure selon l'une des revendications précédentes, comprenant en outre :
des moyens de transmission des valeurs mesurées par le module de mesure de courant de branche (1), dans la boîte de distribution de mesure (2), à un dispositif d'évaluation central.

10. Module solaire photovoltaïque comprenant une pluralité de modules solaires,
dans lequel une boîte de distribution de mesure (2) selon l'une des revendications précédentes est montée sur la face arrière détournée du soleil du module solaire (40) photovoltaïque.

11. Installation photovoltaïque comprenant une pluralité de modules solaires (40) photovoltaïques selon la revendication précédente,
comprenant une pluralité de lignes de branche (10, 10a, 12),
comprenant une boîte de raccordement de générateur,
comprenant au moins un onduleur destiné à l'injection de la puissance électrique produite par le générateur photovoltaïque,

12. Installation photovoltaïque selon la revendication précédente, comprenant un dispositif d'évaluation central destiné à recueillir et à évaluer les valeurs transmises par les modules de mesure de courant de branche des boîtes de distribution de mesure (2).
